# EUROPÄISCHE PATENTSCHRIFT

(11) **EP 0 946 976 B1**
(45) Veröffentlichungstag und Bekanntmachung des Hinweises auf die Patenterteilung: **15.09.2004**
(21) Anmeldenummer: 97936578.0
(22) Anmeldetag: 31.07.1997
(51) Int. Cl.: H01L 21/306, C11D 7/50

(54) **WÄSSRIGE REINIGUNGSLÖSUNG FÜR EIN HALBLEITERSUBSTRAT**
AQUEOUS CLEANING SOLUTION FOR A SEMICONDUCTOR SUBSTRATE
SOLUTION AQUEUSE DE NETTOYAGE POUR SUBSTRAT SEMICONDUCTEUR

(30) Priorität: 02.08.1996 DE 19631363
(43) Veröffentlichungstag der Anmeldung: 06.10.1999
(73) Patentinhaber: Infineon Technologies AG, 81669 München (DE)
(72) Erfinder: MARTIN, Andreas, D-60326 Frankfurt am Main (DE); HUB, Walter, D-81476 München (DE); KOLBESEN, Bernd, D-80339 München (DE)
(74) Vertreter: Banzer, Hans-Jörg, Dipl.-Ing.
(86) Internationale Anmeldenummer: PCT/DE1997/001623
(87) Internationale Veröffentlichungsnummer: WO 1998/006127

(56) Entgegenhaltungen:
- EP-A- 0 407 324
- EP-A- 0 438 727
- EP-A- 0 528 053
- US-A- 5 589 446
- DATABASE WPI Section Ch, Week 9413 Derwent Publications Ltd., London, GB; Class E19, AN 94-104779 XP002046982 & JP 06 053 198 A (HITACHI LTD) , 25.Februar 1994
- DATABASE WPI Section Ch, Week 9143 Derwent Publications Ltd., London, GB; Class E15, AN 91-313788 XP002046983 & JP 03 208 343 A (FUJITSU LTD) , 11.September 1991

## Beschreibung

Die Erfindung bezieht sich auf eine wässrige Reinigungslösung für ein Halbleitersubstrat, die aus einer organischen oder anorganischen Base, Wasserstoffperoxid sowie einem Komplexbildner besteht.

Beim Herstellungsprozeß einer integrierten Schaltung werden zur Entfernung von oberflächlichen Verunreinigungen Mehrfachreinigungsschritte eingeschaltet. Auf der Scheibenoberfläche liegende Verunreinigungen können im einfachsten Fall durch Abblasen mit gereinigtem Stickstoff beseitigt werden. In den meisten Fällen können damit aber nicht alle Partikel entfernt werden. Eine weitere Möglichkeit ist das Abspülen mit gefiltertem deionisiertem Wasser (mit einem Netzmittel)oder mit geeigneten Reinigungschemikalien wie zum Beispiel Azeton oder Isopropanol. Diese Art von Reinigung wird entweder in einem Becken unter Ultraschalleinwirkung (MHz-Frequenzen) durchgeführt, oder die Flüssigkeit wird aus Düsen mit hoher Geschwindigkeit auf die Scheibenoberfläche gespritzt (Jetscrubber). Auch mechanisches Bürsten in einem sogenannten Scrubber wird angewandt und zwar vornehmlich nach CVD-Abscheidungen. Die abgebürsteten Teilchen werden dabei mit deionisiertem Wasser oder einem Lösungsmittel von der Waferoberfläche weggespült.

Im Herstellungsprozeß von integrierten Schaltungen ist in der Regel mehrmals eine chemische Waferreinigung notwendig. Sie erfolgt in der Regel nach dem Entfernen (Strippen) einer Resistmaske und möglichst unmittelbar bevor eine Schicht aufgebracht wird. Dabei werden die Halbleiterwafer entweder in geeignete chemische Bäder eingetaucht, häufig unter Ultraschalleinwirkung, oder die Reinigungsflüssigkeit wird in einem sogenannten Cleaner auf die Scheiben gesprüht.

Ein häufig eingesetztes Verfahren ist die sogenannte RCA-Reinigung (RCA-Review, Seite 187-206, Juni 1970), die aus zwei getrennten Reinigungsschritten besteht:

Beim ersten Reinigungsschritt, der RCA-1 oder SC-1 (Standard Clean 1) wird der zu reinigende Wafer in eine alkalische Reinigungslösung, die aus einem Teil Ammoniak, einem Teil Wasserstoffperoxid und fünf Teilen Wasser besteht, bei einer Temperatur von ca. 70°C getaucht und danach mit einer Reinstwasserspülung nachbehandelt, um Partikel und organische Kontaminationen von der Waferoberfläche zu entfernen.

Danach schließt sich der zweite Reinigungsschritt, RCA-2 oder SC-2 (Standard Clean 2) an. Hierbei wird der zu reinigende Wafer in eine saure Reinigungslösung, die aus einem Teil HCl, einem Teil Wasserstoffperoxid und sechs Teilen Wasser besteht, bei einer Temperatur von ca. 70°C eingetaucht. Danach schließt sich wiederum eine Reinstwasserspülung an, um die unter anderem aus der SC-1 stammenden Metallkontaminationen zu entfernen.

In der Regel sind die Waferoberflächen nach der SC-1-Behandlung mit Fe-, Al-, Ca-, Mg-, Zn-, Cu-Ionen bzw. anderen metallischen Ionen kontaminiert. Diese Metallkontaminationen stammen aus den Prozeßschritten, die unmittelbar vor dem Reinigungsschritt erfolgt sind. Dabei treten Kontaminationen durch Berührung mit Edelstahl, durch Auslaugen von Metallen aus Fittings und Rohrmaterial sowie diverse Metallkontaminationen aus Einzelprozessen der Halbleiterfertigung wie Trockenätzen, Ionen-Implantieren, sowie Beschichten mit Photoresists etc. auf.

Gewöhnlicherweise ist nach der SC-1-Behandlung die Oberfläche des Wafers mit ungefähr 10¹¹ bis 10¹² Eisenatomen pro cm², ungefähr 10¹¹ bis 10¹³ Aluminiumatomen pro cm², und ungefähr 10¹⁰ bis 10¹¹ Atomen pro cm² bei Kupfer und Zink kontaminiert.

Um diesem Problem zu begegnen, werden den Reinigungslösungen mittlerweile diverse Komplexbildner zugesetzt. Zum Beispiel ist aus der DE-A-3822350 ein Verfahren bekannt, bei dem Ethylendiamintetraazetat (EDTA) als Komplexbildner vorgeschlagen wird. Die Verwendung von EDTA aber hat sich als wenig wirksam erwiesen.

Ferner ist aus der EP-A-0276774 eine Reinigungslösung bekannt, bei der fünfwertige Phosphorverbindungen als Komplexbildner vorgeschlagen werden. Auch dieser Lösungsansatz hat sich in der Praxis als wenig wirksam erwiesen.

Schließlich ist aus der EP-A-0496605 ein Verfahren zur Reinigung von Halbleitersubstratoberflächen bekannt, bei dem als Komplexbildner Verbindungen vorgeschlagen werden, die Phosphonsäuregruppen oder deren Salze enthalten. Diese Phosphonsäureverbindungen erweisen sich in der Praxis als sehr wirksam gegen die Kontamination mit Eisenionen, die in der Regel größere Probleme aufwerfen. Andererseits aber weisen die in der EP-A-0496605 vorgeschlagenen Phosphonsäureverbindungen keine komplexierende Wirkung bezüglich Kupfer- und Zinkkontaminationen auf.

Ferner ist allen bekannten naßchemischen Waferreinigungsverfahren zu eigen, daß sie bei einer Temperatur von 70°C durchgeführt werden müssen, was zu erhöhten Kosten und apparativem Aufwand führt. Desweiteren werden bei allen bekannten naßchemischen Reinigungsverfahren zwei Reinigungsschritte, wie sie aus der oben erwähnten RCA-Reinigung herrühren, angewandt.

Aufgabe der vorliegenden Erfindung ist es daher, eine neue Reinigungslösung bereitzustellen, mit der eine erhebliche Kosteneinsparung sowie eine wesentlich erhöhte Effizienz gegenüber den bekannten Reinigungslösungen möglich ist.

Erfindungsgemäß wird die Aufgabe durch eine wässrige Reinigungslösung der eingangs genannten Art gelöst, die dadurch gekennzeichnet ist,
daß als Komplexbildner eine Verbindung der Formel 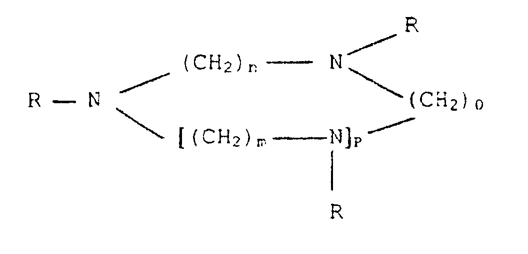 vorgesehen ist, worin R Wasserstoffe und/oder jeweils zwei Stickstoffatome überbrückende aliphatische Ketten und/oder identische oder verschiedene funktionelle Gruppen bedeuten, die
1) die Löslichkeit des Komplexbildners und/oder
2) die Anlagerung des Komplexbildners an das Halbleitersubstrat und/oder
3) die Metallkomplexierungsfähigkeit und/oder
4) die Stabilität des Komplexbildners gegenüber Oxidationsmitteln beeinflußt,
   und m, n, o=2 oder 3 und p=1 oder 2 bedeuten.

Durch diese wässrige Reinigungslösung für Halbleitersubstrate wird eine Kosteneinsparung erzielt, da die Reinigungsschritte reduziert werden, indem im Prinzip nur noch die SC-1 Reinigung stattfindet anstatt der RCA-Sequenz SC-1 und anschließend SC-2. Ferner können die Standzeiten der Reinigungsbäder deutlich erhöht werden und die Reinigung kann bei einer Temperatur von ≤ 50°C durchgeführt werden.

Typischerweise werden Verbindungen verwandt, bei denen als funktionelle Gruppen Karbonsäuregruppen, (Poly)Methylensulfonsäuregruppen, (Poly)Methylensulfinsäuregruppen oder (Poly)Methylensulfensäuregruppen bzw. deren Salze vorgesehen sind.

In einer bevorzugten Ausführung sind als funktionelle Gruppen an den Komplexbildnern Methylenphosphonsäure- oder Polymethylenphosphonsäuregruppen bzw. deren Salze vorgesehen. Die Verwendung von Methylenphosphonsäure- oder Polymethylenphosphonsäuregruppen hat sich als besonders vorteilhaft erwiesen, da mit ihnen die Eisenkontaminationen höchst effizient beseitigt werden können.

Typischerweise können aber an einer Verbindung verschiedene funktionelle Gruppen vorliegen, so daß maßgeschneidert auf die jeweilige Kontaminationsart ein wirksames Instrument am Komplexbildner vorliegt. Insbesondere muß angemerkt werden, daß mit den erfindungsgemäßen Verbindungen Zink-Kontaminationen und Kupfer-Kontaminationen wirksam beseitigt werden können.

Die Konzentration der komplexbildenden erfindungsgemäßen Reinigungslösungen kann zwischen 0,01 bis 1000 ppm betragen. Vorzugsweise ist als organische oder anorganische Base Ammoniak oder ein quaternäres Ammoniumhydroxid wie zum Beispiel Tetramethylenammoniumhydroxid (TMAH) bzw. Cholin vorgesehen, wobei die Konzentration der Base in der erfindungsgemäßen Reinigungslösung von 0,01 bis 20 Gewichts-% betragen kann.

Vorzugsweise enthalten die erfindungsgemäßen Reinigungslösungen 0,01 bis 30 Gewichts-% Wasserstoffperoxid.

Ferner ist vorgesehen, daß eine oder mehrere verschiedene Komplexbildner in einer Reinigungslösung zur Reinigung von Siliciumwafern eingesetzt werden sollen. Bevorzugt sind dabei Amoniak, Wasserstoffperoxid und Wasser in einem Verhältnis von 0,25:1:5 bis 1:1:5.

Die Komplexbildner können wahlweise direkt in den Reinigungslösungen eingesetzt werden. Es ist aber auch denkbar, sie in monomerer oder polymerer Form mit geeigneten Trägermaterialien in Reinigungskolonnen zum kontinuierlichen Recycling der Reinigungslösungen in der Halbleiterfertigung oder in einer eigenen Recyclinganlage einzusetzen.

Das erfindungsgemäße Verfahren wird nun anhand von Beispielen näher erläutert.

Als Reinigungslösung wird eine jeweils frisch angesetzte, verdünnte SC-1-Lösung (1:4:20) verwendet, die wie folgt angesetzt wird: In einem Quarzbecken wird der Wasseranteil (20 Volumenteile) auf 75 °C erhitzt, dann erfolgt die Zugabe von Wasserstoffperoxid (31%, 1 ng/g Qualität, 4 Volumenteile), anschließend die Zugabe der Ammoniaklösung (28%, 1 ng/g Qualität, 1 Volumenteil). Nach jeder Zugabe wird die Lösung durchmischt. Sie erreicht am Ende der Anmischung eine Temperatur von ca. 70 °C. In diese Losung wird gegebenenfalls (siehe unten) eine wässrige Elementstandard-Lösung von Al, Ca, Fe, Ni, Cu und Zn in einer solchen Menge zugegeben, daß im Reinigungsbad eine Addition von 1 ng/g pro Metallion erfolgt. Je nach Versuch wird anschließend oder stattdessen eine Lösung eines erfindungsgemäßen Komplexbildners in einer solchen Menge zugesetzt, daß seine Konzentration im Reinigungsbad 1 µg/g erreicht.

Anschließend werden in die Lösung jeweils mindestens zwei 150 mm Siliziumwafer (100) 10 Minuten lang eingetaucht. Die Wafer haben vorher eine einheitliche Vorreinigung durchlaufen. Sie werden nach dem Test 10 Minuten mit Reinstwasser in einem Überlaufbecken bei 20 °C gespült und trockengeschleudert.
Die Wafer werden anschließend auf metallische Kontamination auf der Vorderseite mittels VPD-AAS bzw. VPD-TRFA untersucht.

### Ausführungsbeispiel 1:

### Verdünnte SC-1 Reinigungslösung mit Zusatz von Komplexbildner N,N',N"-Tri(methylenphosphonium)-1,4,7-triazacyclononan ("c-TRAMP" )

Nach dem Ansetzen des Reinigungsbades gemäß obigem Verfahren wird eine Lösung des Komplexbildners ("cTRAMP") in ammoniakalischer Lösung zugesetzt. Die Mittelwerte der Metallkontaminationen auf den Oberflächen von sechs Testwafern sind in Tabelle 1 angegeben.
Durch die Wirkung des erfindungsgemäßen Komplexbildners wird die Kontamination durch Fe, Ni, Cu und Zn auf den Wafern reduziert (siehe Vergleichsbeispiel 1).

**Tabelle 1:**

| Metallkontamination auf der Waferoberfläche nach SC-1 Reinigung (1:4:20, 70°C) mit Komplexbildner cTRAMP (1µg/g) | | | | | |
|---|---|---|---|---|---|
| Reinigungslösung | Metallkontamination auf der Waferoberfläche (1010 Atome pro cm2) | | | | |
| | Ca | Fe | Ni | Cu | Zn |
| SC-1+ cTRAMP | 4,3 | <0,2 | <0,1 | <0,1 | 0,5 |

### Ausführungsbeispiel 2:

### Verdünnte SC-1 Reinigungslösung mit Zusatz von je 1 ng/g Al, Ca, Fe, Ni, Cu, Zn und Komplexbildner N,N',N"-Tri(methylenphosphonium)-1,4,7-triazacyclononan ("cTRAMP")

Nach dem Ansetzen des Reinigungsbades (Volumen 18,75 l) gemäß obigem Verfahren wurden 1,875 ml einer wässrigen Multielement-Lösung von Al, Ca, Cu, Fe, Ni und Zn von jeweils 10 µg/g gegeben, so daß im Reinigungsbad eine Konzentration von 1 ng/g von jedem dieser Elemente zugesetzt wird. Anschließend erfolgt die Zugabe des Komplexbildners N,N',N"-Tri(methylenphosphonium)-1,4,7-triazacyclononan ("cTRAMP") in ammoniakalischer Lösung. Die Metallkontamination auf den Oberflächen von zwei Testwafern sind in Tabelle 2 angegeben. Das Ergebnis zeigt, daß der Komplexbildner die Abscheidung der Metalle Fe, Ni, Cu und Zn auch in der stark kontaminierten Reinigungslösung verhindert (siehe Vergleichsbeispiel 2). Die Waferoberflächen sind vergleichbar sauber wie in Ausführungsbeispiel 1 und damit sauberer als mit hochreinen Chemikalien ohne Zusatz von Komplexbildner (Vergleichsbeispiel 1).

**Tabelle 2:**

| Metallkontamination auf der Waferoberfläche nach SC-1 Reinigung (1:4:20, 70°C) unter Zusatz von 1ng/g von Al, Ca, Fe, Ni, Cu, Zn und Komplexbildner cTRAMP | | | | | |
|---|---|---|---|---|---|
| Reinigungslösung | Metallkontamination auf der Waferoberfläche (1010 Atome pro cm2) | | | | |
| | Ca | Fe | Ni | Cu | Zn |
| SC-1 + Metalle (1ng/g)+ cTRAMP | 9,2 | <0,2 | <0,1 | <0,1 | 0,5 |

### Ausführungsbeispiel 3:

### Verdünnte SC-1 Reinigungslösung mit Zusatz von je 1 ng/g Al, Ca, Fe, Ni, Cu, Zn und den Komplexbildnern Diethylenetriaminepenta(methylenephosphonic)acid ("DTTP") and 1,4,8,11-Tetraazacyclotetradecane-N,N',N",N'"(tetraecetic)acid ("TETA")

Bei diesem Versuch zum Studium der Wirkung eines erfindungsgemäßen Komplexbildners bezüglich Aluminium erfolgte die Zugabe der Metallionen in das vorgelegte DIW (75°C) vor der Zugabe von TETA (300 µg/g), DTTP (4 µg/g), H2O2 und NH4OH.

Der Vergleich der Oberflächenbelegung mit Vergleichsbeispiel 5 zeigt, daß der Komplex-bildner TETA die Abscheidung von Al auf den Scheiben verhindert.

**Tabelle 3:**

| Metallkontamination auf der Waferoberfläche nach SC-1 Reinigung (1:4:20, 70°C) unter Zusatz von 1ng/g von Al, Ca, Fe, Ni, Cu, Zn und den Komplexbildnern DTTP (4 9 µg/g) und TETA (300 µg/g) | |
|---|---|
| Reinigungslösung | Kontamination auf der Waferoberfläche (1010 Atome pro cm2) |
| | Al |
| SC-1 + Metalle (1ng/g)+ DTTP + TETA | 100 |

### Vergleichsbeispiel 1:

### Verdünnte SC-1 Reinigungslösung ohne Komplexbildner

Derselbe Versuch wie im Anwendungsbeispiel 1 allerdings ohne Zusatz eines Komplexbildners führt bei 18 Testwafern zu den in Tabelle 4 aufgeführten mittleren Kontaminationswerten. Die Kontamination wird bestimmt durch die Reinheit der verwendeten Chemikalien sowie die Versuchsbedingungen.

**Tabelle 4:**

| Metallkontamination auf der Waferoberfläche nach SC-1 Reinigung (1:4:20, 70°C) | | | | | |
|---|---|---|---|---|---|
| Reinigungslösung | Metallkontamination auf der Waferoberfläche (1010 Atome pro cm2) | | | | |
| | Ca | Fe | Ni | Cu | Zn |
| SC-1 | 3,8 | 3,5 | 0,3 | 0,2 | 4,4 |

### Vergleichsbeispiel 2:

### Verdünnte SC-1 Reinigungslösung mit Zusatz von je 1ng/g Al, Ca, Fe, Ni, Cu und Zn ohne Komplexbildner

Nach dem Ansetzen der Reinigungslosung wie oben beschrieben wurde die Lösung der angegebenen Metallionen zugegeben und der Wafertest durchgeführt. Die Mittelwerte der Metallkontaminationen auf der Oberfläche von 15 Wafern sind in Tabelle 5 angegeben. Es zeigt sich eine deutliche Kontamination an Fe, Ni und Zn.

**Tabelle 5:**

| Metallkontamination auf der Waferoberfläche nach SC-1 Reinigung (1:4:20, 70°C) unter Zusatz vcn 1ng/g von Al, Ca, Fe, Ni, Cu, Zn ohne Komplexbildner | | | | | |
|---|---|---|---|---|---|
| Reinigungslösung | Metallkontamination auf der Waferoberfläche (1010 Atome pro cm2) | | | | |
| | Ca | Fe | Ni | Cu | Zn |
| SC-1 + Metalle (1ng/g) | 4,1 | 120 | 1,0 | 0,3 | 32 |

### Vergleichsbeispiel 3

### Verdünnte SC-1 Reinigungslösung mit Zusatz von 1 ng/g Al, Ca, Fe, Ni, Cu und Zn und Komplexbildner Ethylendiamintetraazetat (EDTA)

Nach dem Ansetzen der Reinigungslösung (1:4:20, 70°C) wie oben wurde zunächst die Lösung der Metallionen und anschließend der Komplexbildner (EDTA) in einer Konzentration von 1 µg/g zugesetzt. Die darauf folgende Reinigung von 8 Testwafern ergab die in Tabelle 6 enthaltenen Mittelwerte der Kontaminationen. Hierin zeigt sich, daß EDTA keine ausreichende Komplexbindungswirkung bezüglich der zugesetzten Metalle in der verdünnten SC-1 Lösung bei 70 °C aufweist.

**Tabelle 6:**

| Metallkontamination auf der Waferoberfläche nach SC-1 Reinigung (1:4:20, 70°C) unter Zusatz von 1ng/g von Al, Ca, Fe, Ni, Cu, Zn und Komplexbildner EDTA (1 µg/g) | | | | | |
|---|---|---|---|---|---|
| Reinigungslösung | Metallkontamination auf der Waferoberfläche (1010 Atome pro cm2 | | | | |
| | Ca | Fe | Ni | Cu | Zn |
| SC-1 + Metalle (1ng/g) + EDTA (1 µg/g) | 3,8 | 32 | <0, 1 | 0,1 | 13 |

### Vergleichsbeispiel 4

### Verdünnte SC-1 Reinigungslösung mit Zusatz von Komplexbildner EDTA

Nach dem Ansetzen der Reinigungslösung wie open wurde der Komplexbildner Ethylendiamintetraazetat (EDTA) in einer Konzentration von 1 ug/g zugesetzt. Die anschließende Reinigung von 8 Testwafern ergab die in Tabelle 7 enthaltenen Mittelwerte der Kontaminationen.

Es zeigt sich, daß EDTA die in der Reinigungslösung vorhandenen Fe-, Ni-, Cu- und Zn-Ionen nicht ausreichend (im Vergleich mit cTRAMP) komplexieren kann.

**Tabelle 7:**

| Metallkontamination auf der Waferoberfläche nach SC-1 Reinigung (1:4:20, 70°C) unter Zusatz von Komplexbildner EDTA (1 µg/g) | | | | | |
|---|---|---|---|---|---|
| Reinigungslösung | Metallkontamination auf der Waferoberfläche (1010 Atome pro cm2) | | | | |
| | Ca | Fe | Ni | Cu | Zn |
| SC-1 + EDTA (1 µg/g) | 6,7 | 2,6 | 0,3 | 0,1 | 4,2 |

### Vergleichsbeispiel 5:

### Verdünnte SC-1 Reinigungslösung mit Zusatz von je 1 ng/g Al, Ca, Fe, Ni, Cu, Zn mit und ohne Komplexbildner Diethylenetriaminepenta(methylenephosphonic)acid ("DTTP")

Bei diesem Versuch zum Studium der Wirkung eines erfindungsgemäßen Komplexbildners bezüglich Aluminium erfolgte die Zugabe der Metallionen in das vorgelegte DIW (75°C) vor der Zugabe von DTTP (4 µg/g), H2O2 und NH4OH. Die Aluminiumkonzentrationen auf Wafern nach SC-1 bzw. nach SC-1 mit DTTP sowie nach SC-1 mit Zusatz von Metallen (1 ng/g) und DTTP (4 µg/g) sind in Tabelle 8 enthalten.

Die Ergebnisse zeigen einen hohen Anstieg von Aluminium auf der Waferoberfläche nach Zusatz der Metalle zur SC-1 - Lösung. DTTP zeigt keine Wirkung bezüglich Al.

**Tabelle 8:**

| Metallkontamination auf der Waferoberfläche nach SC-1 Reinigung (1:4:20, 70°C) mit und ohne Zusatz von 1ng/g von Al, Ca, Fe, Ni, Cu, Zn sowie mit und ohne Komplexbildner DTTP (4 µg/g) | |
|---|---|
| Reinigungslösung | Kontamination auf der Waferoberfläche (1010 Atome pro cm2) |
| | Al |
| SC-1 + Metalle (1ng/g) | 2000 |
| SC-1 | 100 |
| SC-1 + DTTP | 100 |

## Patentansprüche

1. Wässrige Reinigungslösung für ein Halbleitersubstrat, bestehend aus:
a) einer organischen oder anorganischen Base,
b) Wasserstoffperoxid sowie
c) einem Komplexbildner,
**dadurch gekennzeichnet,**
**dass** als Komplexbildner eine Verbindung der Formel 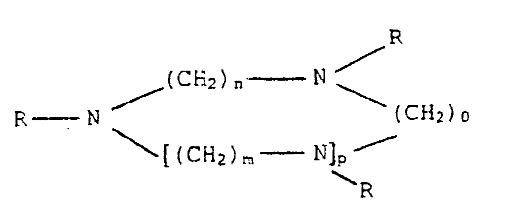 vorgesehen ist, worin R Wasserstoffe und/oder jeweils zwei Stickstoffatome überbrückende aliphatische Ketten und/oder identische oder verschiedene funktionelle Gruppen bedeuten, die
1) die Löslichkeit des Komplexbildners und/oder
2) die Anlagerung des Komplexbildners an das Halbleitersubstrat und/oder
3) die Metallkomplexierungsfähigkeit und/oder
4) die Stabilität des Komplexbildners gegenüber Oxidationsmitteln beeinflusst,
und m, n, o=2 oder 3 und p=1 oder 2 bedeuten.

2. Wässrige Reinigungslösung nach Anspruch 1,
**dadurch gekennzeichnet,**
**dass** als funktionelle Gruppen Carbonsäuregruppen, (Poly)Methylensulfonsäuregruppen, (Poly)Methylensulfinsäuregruppen oder (Poly)Methylensulfensäuregruppen bzw. deren Salze vorgesehen sind.

3. Wässrige Reinigungslösung nach Anspruch 1,
**dadurch gekennzeichnet,**
**dass** als funktionelle Gruppen Methylenphosphonsäure- oder Polymethylenphosphonsäuregruppen bzw. deren Salze vorgesehen sind.

4. Wässrige Reinigungslösung nach einem der Ansprüche 1 bis 3,
**dadurch gekennzeichnet,**
**dass** sie 0,01 bis 1000 ppm Komplexbildner enthält.

5. Wässrige Reinigungslösung nach einem der Ansprüche 1 bis 4,
**dadurch gekennzeichnet,**
**dass** als organische oder anorganische Base Ammoniak oder ein quaternäres Ammoniumhydroxid vorgesehen ist.

6. Wässrige Reinigungslösung nach Anspruch 5,
**dadurch gekennzeichnet,**
**dass** sie 0,01 bis 20 Gewichts-% der organischen oder anorganischen Base enthält.

7. Wässrige Reinigungslösung nach einem der Ansprüche 1 bis 6,
**dadurch gekennzeichnet,**
**dass** sie 0,01 bis 30 Gewichts-% Wasserstoffperoxid enthält.

## Claims

1. Aqueous solution for cleaning a semiconductor substrate, consisting of:
a) an organic or inorganic base,
b) hydrogen peroxide and
c) a complexing agent,
**characterized in that** the complexing agent provided is a compound of the formula 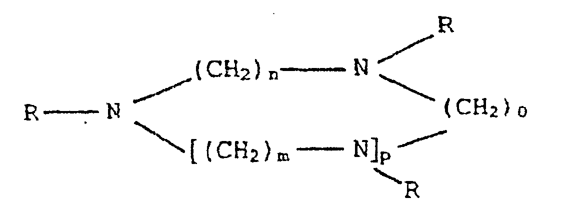 in which the R radicals are hydrogen atoms and/or aliphatic chains bridging two nitrogen atoms each and/or identical or different functional groups, which affects
1) the solubility of the complexing agent and/or
2) the adduction of the complexing agent onto the semiconductor substrate and/or
3) the metal-complexing ability and/or
4) the stability of the complexing agent to oxidants,
and m, n and o are 2 or 3, and p is 1 or 2.

2. Aqueous cleaning solution according to Claim 1, **characterized in that** the functional groups provided are carboxylic acid groups, (poly)methylenesulphonic acid groups, (poly)methylenesulphinic acid groups or (poly)methylenesulphenic acid groups, or salts thereof.

3. Aqueous cleaning solution according to Claim 1, **characterized in that** the functional groups provided are methylenephosphonic acid or polymethylenephosphonic acid groups, or salts thereof.

4. Aqueous cleaning solution according to one of Claims 1 to 3, **characterized in that** it contains from 0.01 to 1000 ppm of complexing agent.

5. Aqueous cleaning solution according to one of Claims 1 to 4, **characterized in that** the organic or inorganic base provided is ammonia or a quaternary ammonium hydroxide.

6. Aqueous cleaning solution according to Claim 5, **characterized in that** it contains from 0.01 to 20% by weight of the organic or inorganic base.

7. Aqueous cleaning solution according to one of Claims 1 to 6, **characterized in that** it contains from 0.01 to 30% by weight of hydrogen peroxide.

## Revendications

1. Solution aqueuse de nettoyage d'un substrat semi-conducteur, constituée :
a) d'une base organique ou inorganique,
b) de peroxyde d'hydrogène, ainsi que
c) d'un agent complexant,
**caractérisée en ce qu'**il est prévu comme agent complexant un composé de la formule 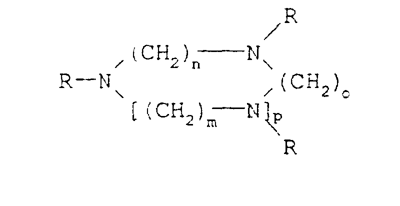 dans laquelle les R représentent des hydrogènes et/ou des chaînes aliphatiques pontant chacune deux atomes d'azote et/ou des groupes fonctionnels identiques ou différents qui influent sur
1) la solubilité de l'agent complexant et/ou
2) le dépôt de l'agent complexant sur le substrat semi-conducteur et/ou
3) la capacité de complexation de métaux et/ou
4) la stabilité de l'agent complexant vis-à-vis des agents oxydants,
et m, n, o valent 2 ou 3 et p vaut 1 ou 2.

2. Solution de nettoyage aqueuse selon la revendication 1, **caractérisée en ce qu'**il est prévu comme groupes fonctionnels des groupes acides carboxyliques, des groupes acide (poly)méthylènesulfonique, des groupes acide (poly)méthylènesulfinique ou des groupes acide (poly)méthylènesulfénique ou leurs sels.

3. Solution de nettoyage aqueuse selon la revendication 1, **caractérisée en ce qu'**il est prévu comme groupes fonctionnels des groupes acide méthylènephosphonique ou acide polyméthylènephosphonique ou leurs sels.

4. Solution de nettoyage aqueuse selon l'une des revendications 1 à 3, **caractérisée en ce qu'**elle contient de 0,01 à 1000 ppm d'agent complexant.

5. Solution de nettoyage aqueuse selon l'une des revendications 1 à 4, **caractérisée en ce qu'**il est prévu comme base organique ou inorganique de l'ammoniaque ou un hydroxyde d'ammonium quaternaire.

6. Solution de nettoyage aqueuse selon la revendication 5, **caractérisée en ce qu'**elle contient de 0,01 à 20% en poids de la base organique ou inorganique.

7. Solution de nettoyage aqueuse selon l'une des revendications 1 à 6, **caractérisée en ce qu'**elle contient de 0,01 à 30% en poids de peroxyde d'hydrogène.
